# EUROPEAN PATENT SPECIFICATION

(11) **EP 3 293 530 B1**
(45) Date of publication and mention of the grant of the patent: **30.03.2022**
(21) Application number: 16187738.6
(22) Date of filing: 08.09.2016
(51) Int. Cl.: G01R 27/06, H01P 5/18

(54) **SCANNING UNIT, DIRECTIONAL COUPLER AND MEASUREMENT SYSTEM**
ABTASTEINHEIT, RICHTKOPPLER UND MESSSYSTEM
UNITÉ DE BALAYAGE, COUPLEUR DIRECTIONNEL ET SYSTÈME DE MESURE

(43) Date of publication of application: 14.03.2018
(73) Proprietor: Rohde & Schwarz GmbH & Co. KG, 81671 München (DE)
(72) Inventor: Eichstetter, Thomas, 85354 Freising (DE); Gutsche, Thomas, 81673 München (DE); Boegl, Thomas, 86179 Augsburg (DE)
(74) Representative: Prinz & Partner mbB

(56) References cited:
- EP-A1- 2 961 037
- GB-A- 1 573 536
- US-A- 3 701 057
- US-A- 5 864 259

## Description

The invention relates to a directional coupler for high-frequency applications and a measuring system.

In general, scanning units are inter alia used to measure a signal in a line, for instance a current in a current leading line which can also be called a live line. The scanning unit can be provided as a single device for measuring the signal in a separate device. Alternatively, scanning units can be used in a certain device in order to measure the signal in an internal line of this certain device, for instance a signal leading line in a measurement system comprising a directional coupler, a network analyzer, an oscilloscope and/or a spectrum analyzer.

For example, a directional coupler comprises or rather provides a scanning unit wherein such a directional coupler can be used to determine the power of forward and rearward propagating electromagnetic waves through a line by measuring the corresponding currents and voltages. Thus, the power standing wave ratio, also called voltage standing wave ration (VSWR), can be determined which is a measure of impedance matching of the impedance of a load, for instance an antenna, and a source which are connected with each other via the line to be measured. These measuring results can be used to adapt the antenna wherein a separate antenna tuner is typically used. The antenna tuner comprises several coils and a network of capacitors wherein the antenna tuner is arranged between the antenna and the directional coupler or rather scanning unit.

Further, scanning units are known which may be configured such that the current of a signal is measured in an inductive manner, for instance by using a current transformer (Bruene bridge). Typically, a ring-shaped ferrite core is used which encircles the current leading line. The magnetic field of the current flowing through this line interacts with the ring-shaped ferrite core such that a current is induced in the ferrite core. This induced current is used for determining the current flowing through the line to be scanned, in particular its amperage.

A directional coupler with such a scanning unit that uses a ring-shaped ferrite core is shown in US 3,701,057.

In GB 1 573 536, a scanning unit is shown that is used for measuring a variable electromagnetic field wherein coaxial coils are used that may be assigned to a ferrite core as well.

However, the ferrite core swings during the measurement because of the induced electromagnetic forces resulting in vibrations which might be disturbing. In addition, the mechanical stresses of the scanning unit as well as the device comprising such a scanning unit are high due to the moving ferrite core. Furthermore, the ferrite core is expensive and large with respect to the other components which are typically used.

The invention provides a directional coupler as described in the claims.

A directional coupler for high-frequency applications is provided that comprises a scanning unit, in particular a scanning unit as mentioned above, wherein the scanning unit comprises a measuring coil and a current-to-voltage converter which is connected to the measuring coil wherein the scanning unit is configured such that a current is measured in an inductive manner by the measuring coil. The directional coupler is formed on a printed circuit board. The induced current is converted into a voltage with a linear dependency. The signals, in particular forward and rearward propagating signals, can be measured without any elements containing ferrite. Therefore, the directional coupler is less expensive with respect to the usual directional couplers having or rather being scanning units. Furthermore, the height of the directional coupler is reduced. The line to be measured by the scanning unit is a transmission line having a defined wave impedance. The measuring coil and the current-to-voltage converter define a current scanning portion of the scanning unit.

As the directional coupler is formed on a printed circuit board, a microstrip directional coupler may be provided wherein the power of the signals propagating through the line can be determined, in particular the forward power and the rearward power. Further, a very compact directional coupler is provided which is less expensive. In addition, the directional coupler is more resistant as no vibrating/moving parts are used in order to measure the signals.

The invention is based on the finding that the current flowing through the line to be measured can already be measured by a measuring coil being disposed (immediately) adjacent to the line to be measured such that the magnetic field of the current directly induces an induced current in the measuring coil wherein the induced current corresponds to the current flowing through the line being scanned. A ferrite core or any other ferrite containing element is not necessary for measuring the current. Hence, the costs of the scanning unit can be reduced as well as its dimensions. In addition, the reliability and the customer satisfaction are improved since no moving or rather vibrating parts are used for measuring the current. The inlet side of the current-to-voltage converter is connected to the measuring coil such that the induced current is converted into a voltage for further processing.

For instance, the scanning unit comprises a measuring coil and an active impedance matching circuit having a current-to-voltage converter which is connected to the measuring coil wherein the scanning unit is configured such that a current in a line to be scanned is measured in an inductive manner by the measuring coil wherein a feedback network is provided which has at least one resistance.

Moreover, the measuring coil is connected to the active impedance matching circuit, in particular the current-to-voltage converter, such that the induced current flows freely through a virtual shortcut. Accordingly, an input impedance of the active impedance matching circuit is provided being very low, in particular zero. The relationship of the current in the line and the converted voltage is frequency-independent resulting in a constant antenna factor between the line and the measuring coil.

In general, the measuring results can be used to adapt an antenna connected to the scanning unit, in particular its impedance, wherein the active impedance matching circuit of the scanning unit is set accordingly. Thus, it is ensured that an antenna connected with the scanning unit can be adapted frequency-dependently by the scanning unit, in particular the inductive measured current and the active impedance matching circuit.

As no ferrite containing element encircling the line to be scanned is needed, the measuring coil and the line may be arranged in a same plane. In other words, the measuring coil does not encircle the line through which the signal to be scanned propagates. Accordingly, a smaller scanning unit can be provided, in particular with regard to its height. The measuring coil comprising at least one winding defines a plane wherein the line to be scanned lies in this plane at least with its portion which interacts with the measuring coil.

Preferably, the measuring coil has two or more windings. The number of windings is important for the lower frequencies of the signal to be measured. Thus, low frequencies in the high frequency range can be measured, for instance frequencies below 30 MHz, particularly between 1 MHz and 30 MHz.

In general, the scanning unit may comprise a current scanning portion and a voltage scanning portion. The current scanning portion comprises the measuring coil and the current-to-voltage converter. The voltage scanning portion can be provided by a capacitive voltage divider. The current scanning portion and the voltage scanning portion are used to determine the respective powers, in particular the forward power and the rearward power.

According to an aspect, at least one capacitor is provided being connected parallel to the at least one resistance in order to provide an electrical bypass of the at least one resistance. This electrical bypass line can be used for higher frequency signals such that the high frequency signals may bypass the at least one resistance of the feedback network. The capacitor can also be called feedback capacitor which ensures a stable operation of the scanning unit since the capacitor improves the stability response of the feedback network.

Further, the current-to-voltage converter may comprise a transistor network. The transistor network can be used to convert the induced current into a corresponding voltage signal which can be processed by the active impedance matching circuit. The several transistors are connected to each other such that the induced current is converted accordingly.

Particularly, the current-to-voltage converter comprises an operational amplifier, for instance a differential operational amplifier. A lower cut-off frequency can be ensured when using an operational amplifier instead of a transistor network. Thus, the scanning unit is configured to scan signals having a very low frequency in the high frequency range, in particular about 1 MHz. In addition, the voltage corresponding to the induced current may be amplified for further processing by the scanning unit.

According to another aspect, a bypass line connects the measuring coil and an output of the scanning unit directly wherein the bypass line is switchable. This bypass line can be a direct line which bypasses the operational amplifier accordingly. The user of the scanning unit may control the scanning unit such that the switchable bypass line is activated or not. Therefore, signals transmitted via the direct line are not amplified.

Furthermore, a capacitor may be connected in series with the current-to-voltage converter wherein the capacitor is provided on the outlet side of the current-to-voltage converter. This capacitor can be used to block direct current voltages.

According to another aspect, a balun circuit is provided on the outlet side of the current-to-voltage converter wherein the balun circuit has a symmetrical port, in particular a coaxial port. A balun circuit also known as balanced-unbalanced circuit is typically used to link a symmetrical (balanced) circuit to an asymmetrical (unbalanced) circuit or vice versa. Further, the balun circuit may be used as an ideal impedance converter. For instance, the balun circuit is configured such that a perfect 180° phase shifted signal is outputted as the balun circuit blocks or rather refuses unbalanced parts of the signals.

Further, an adjustable filter may be provided, in particular a bandpass filter and/or a notch filter. Thus, unwanted disturbing signals can be attenuated by the adjustable filter, for instance mobile radio and/or television signals. The adjustable filter may be provided in the active impedance matching circuit. The filter may be a part of an attenuation unit.

The scanning unit may comprise a bias tee for applying an operating voltage, in particular via the symmetrical port of the balun circuit. The bias tee is also called bias tee network. It can be used to insert a direct current voltage for adjusting an electronic component, in particular an adjustable filter and/or the operational amplifier. Thus, the direct current bias point of the electronic component may be set by the direct current inserted via the bias tee.

Particularly, the scanning unit is ferrite-less. Thus, the scanning unit does not have any vibrating elements during the scanning operation which are used for measuring the current of the line to be scanned. Hence, the scanning unit is less expensive and it can be formed in a compact manner, in particular with regard to the height.

According to an aspect, the directional coupler is a broadband directional coupler. The directional coupler may decouple and/or couple electromagnetic waves with a frequency of 1 MHz to 30 MHz being in the high frequency range.

The scanning unit of the directional coupler may comprise an active impedance matching circuit. Thus, an antenna connected to the directional coupler can be adapted in a frequency-dependent manner by the directional coupler directly over a wide frequency range.

Moreover, the directional coupler comprises an adding unit, also called summer, and/or a subtracting unit, also called subtractor, which are used to determine the forward power and backward power. The forward and backward powers can be determined by using transformed quantities which relate to currents and voltages measured by the current scanning portion of the scanning unit as well as an additional voltage scanning portion. Thus, the information regarding the current and voltage is used for determining the powers via the adding and/or subtracting units. For instance, the transformed quantities relating to the measured current and voltage are added in the adding unit in order to determine the forward power whereas the transformed quantities relating to the measured current and voltage are subtracted in the subtracting unit in order to determine the rearward power.

Further, a measuring system is provided that comprises a scanning unit as mentioned above and/or a directional coupler as mentioned above. Such a measuring system has the same advantages since the measuring system can be provided less expensive wherein the measuring system has a higher mechanical resistance as no vibrating/moving parts are used in order to measure the signals in the line to be measured. In addition, the dimensions of the measuring system can be reduced as the dimensions of the current scanning portion of the scanning unit are reduced, in particular the height.

The measuring system may further comprise a vector network analyzer, an oscilloscope and/or a spectrum analyzer. The scanning unit can be used to scan signals regarding their power whereas the vector network analyzer, the oscilloscope and/or the spectrum analyzer are provided for further analyses. Accordingly, these signals can be measured in an efficient way. For instance, a vector network analyzer is connected to the directional coupler in order to analyze the corresponding electromagnetic waves being decoupled.

The invention will now be described with reference to the accompanying drawings. In the drawings,
- Figure 1 shows a scanning unit used by a directional coupler according to the invention in a schematic sketch,
- Figure 2 schematically shows a directional coupler according to the invention which is realized on a printed circuit board,
- Figure 3 shows the directional coupler shown in Figure 2 in a schematic sketch.

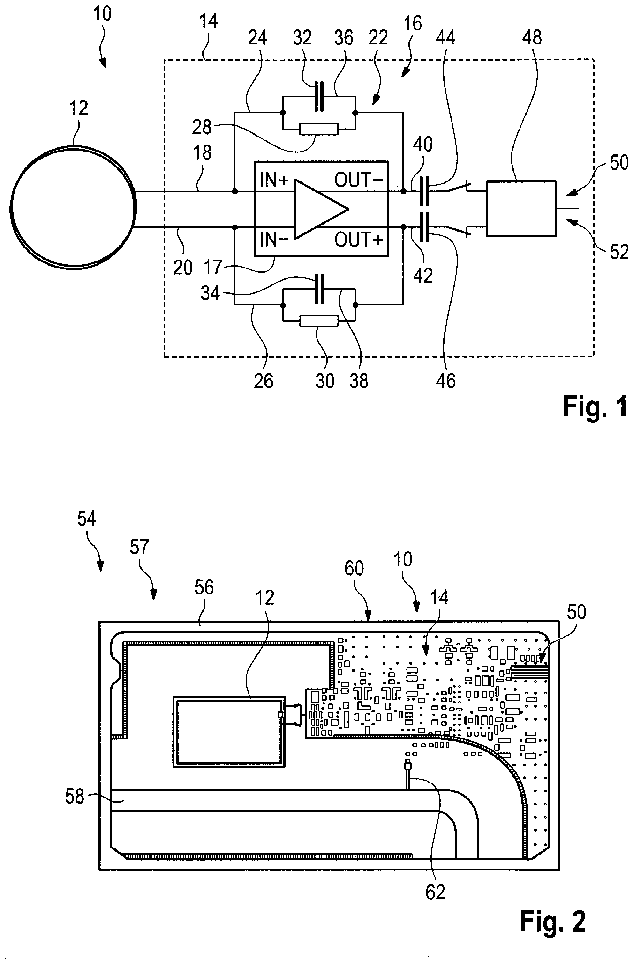

In Figure 1, a scanning unit 10 is shown which comprises a measuring coil 12 and an active impedance matching circuit 14.

In the shown embodiment, the measuring coil 12 has two windings wherein the measuring coil 12 interacts with a live line (not shown in Figure 1) such that the current of a signal propagating through the live line induces a current in the measuring coil 12 which is used to determine the amperage of the signal in the live line.

The measuring coil 12 is connected to the active impedance matching circuit 14 which comprises a current-to-voltage converter 16 being directly coupled to the measuring coil 12 via a first input line 18 and a second input line 20. In the shown embodiment, the current-to-voltage converter 16 comprises an operational amplifier 17. Preferably, the operational amplifier 17 has a high gain bandwidth product.

Further, the active impedance matching circuit 14 comprises a feedback network 22 which comprises two feedback lines 24, 26 each having at least one resistance 28, 30 wherein the feedback lines 24, 26 and the dedicated resistances 28, 30 correspond to the first input line 18 and the second input line 20. The feedback lines 24, 26 can also be called feedback branches.

The feedback network 22 further comprises two capacitors 32, 34 which each are connected in parallel to the resistances 28, 30 such that bypass lines 36, 38 are provided for each resistance 28, 30 in the dedicated lines 24, 26. These capacitors 32, 34 ensure a stable operation of the scanning unit 10. Since the capacitors 32, 34 are part of the feedback network 22, the capacitors 32, 34 can be called feedback capacitors.

The current-to-voltage converter 16 further comprises two outlet lines 40, 42 which are directly connected to the operational amplifier 17. Further, these outlet lines 40, 42 are part of the feedback network 22 since the lines 24, 26 are connected to the input lines 18, 20 as well as the output lines 40, 42.

In each of the output lines 40, 42, a capacitor 44, 46 is provided which is connected in series with the current-to-voltage converter 16, in particular the operational amplifier 17.

The output lines 40, 42 are further connected to a balun circuit 48 which may comprise a transformer. The balun circuit 48 has a symmetrical port 50, in particular a coaxial port. In general, the balun circuit 48 ensures that a balanced signal is outputted, in particular a signal having a perfect phase shift of exactly 180°.

Moreover, a bias tee network 52 is provided such that a direct current can be inserted, for instance via the symmetrical port 50 of the balun circuit 48.

In operation, the current induced in the measuring coil 12 does not flow via the input lines 18, 20 to the inlets of the operational amplifier 17 as the induced current flows via the resistances 28, 30 of the feedback network 22 such that a voltage is generated being proportional to the current inputted to the current-to-voltage converter 16. Thus, the induced current is converted to a voltage with a linear dependence wherein this voltage is used as input parameter for the operational amplifier 17.

Accordingly, the current-to-voltage converter 16 is formed by the operational amplifier 17 and the feedback network 22 partly.

As the induced current flows freely through the virtual shortcut on the input side of the active impedance matching circuit 14, an input impedance is provided being very low, in particular zero. Accordingly, the relationship of the current in the line to be scanned and the generated voltage on the input side is frequency-independent resulting in a constant antenna factor between the line to be scanned and the measuring coil 12.

Due to the feedback network 22 comprising the operational amplifier 17 and the feedback lines 24, 26, it is ensured that the impedance can be matched in an active manner.

Furthermore, a RC element can be provided between both input lines 18, 20 (not shown in Figure 1). The RC element is disposed at the input side of the current-to-voltage converter 16, in particular the operational amplifier 17. Accordingly, the frequency range of the scanning unit 10 can be set by this RC element.

Moreover, the active impedance matching circuit 14 may have an attenuation unit (not shown in Figure 1) which may be provided between the capacitors 44, 46 and the balun circuit 48. For instance, the attenuation unit comprises adjustable filters such as bandpass filters and/or notch filters which can be set via the bias tee network 52. Particularly, a corresponding direct current is inputted via the bias tee network 52 in order to set the electrically adjustable filters.

Furthermore, a further bypass line may be provided which directly connects the measuring coil 12 and an output of the switching unit 10. Thus, the direct line bypasses the operational amplifier 17 such that the induced signal may be outputted at an output of the scanning unit 10 without being amplified. Further, this direct line may be configured such that it is switchable manually or automatically.

As the scanning unit 10 scans or rather measures the current of a signal in an inductive manner by the measuring coil 12, the scanning unit 10 is ferrite-less as no ferrite core or any other ferrite containing element is required to measure the current. Thus, the scanning unit 10 is less expensive and it has smaller dimensions.

In Figure 2, a directional coupler 54 is shown which is formed on a printed circuit board 56. The directional coupler 54 comprises a scanning unit 10 as described above wherein the same components have the same reference signs. Thus, a measurement system 57 is formed.

Furthermore, the directional coupler 54 has at least one line 58 through which a signal propagates which can be measured by the scanning unit 10.

The scanning unit 10 is also provided on the printed circuit board 56. Accordingly, the measuring coil 12 and the line 58 are arranged in the same plane which is defined by the printed circuit board 56 as well as the windings of the measuring coil 12. It is not necessary that a ring-shaped ferrite core encircles the line 58. Thus, a very small directional coupler 54 can be provided, in particular the height of the scanning unit 10 being part of the directional coupler 54 is reduced.

As already mentioned above with regard to the scanning unit 10, a current is induced in the measuring coil 12 which is used to measure the current of the signal propagating through the line 58. Hence, the measuring coil 12 and the current-to-voltage converter 16 form a current scanning portion 60 of the scanning unit 10.

The scanning unit 10 further comprises a voltage scanning portion 62 which is directly connected to the line 58 as already shown in Figure 2. The voltage scanning portion 62 may comprise a capacitive voltage divider with an impedance of maximal 200 Ω at its secondary side.

Preferably, the current scanning portion 60 and the voltage scanning portion 62 have the same attenuation and phase shifting characteristics.

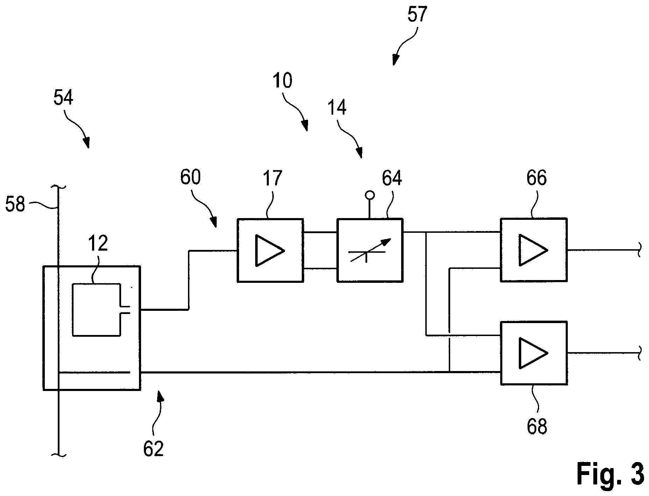

The directional coupler 54 and the whole scanning unit 10 are shown in Figure 3 in a schematic sketch. As shown, the measuring coil 12 is arranged (directly) adjacent to the transmission line 58.

In Figure 3, an attenuation unit 64 being part of the scanning unit 10 is shown which is arranged next to the operational amplifier 17, in particular after the operational amplifier 17. The attenuation unit 64 may comprise the adjustable filters which can be adjusted electrically, for instance via the bias tee 52 of the scanning unit 10.

The scanning unit 10 of the directional coupler 54 comprises the current scanning portion 60 as well as the voltage scanning portion 62 wherein the current scanning portion 60 measures the current in the line 58 in an inductive manner via the measuring coil 12 being arranged (immediately) adjacent to the line 58.

The directional coupler 54 further comprises an adding unit 66, also called summer, as well as a subtraction unit 68, also called subtractor, which each are coupled to the current scanning portion 60 and the voltage scanning portion 62. These units 68, 68 are used to combine the measured or rather scanned parameters such that the forward power and backward power of the signals can be determined, respectively. In fact, corresponding voltages are determined as the currents have been converted. Nevertheless, the determined voltages correspond to the dedicated powers. The units 66, 68 may comprise a corresponding operational amplifier for adapting the impedances accordingly.

The line 58 may be a transmission line which may be used for transmitting a radio frequency signal to an antenna connected with the directional coupler 54 or for transmitting a received signal by the antenna.

This signal is decoupled via the directional coupler 54 or rather the scanning unit 10 and analyzed regarding its forward power and its rearward power wherein the current is taken in an inductive manner via the current scanning portion 60.

Depending on the determined power relation, in particular the voltage standing wave ratio, the antenna may be adapted to the line 58 or rather the source or the load connected to the other end of the line 58, in particular their corresponding impedances.

Thus, a direct adaption of the antenna connected to the line 58 is ensured via the directional coupler 54 and the scanning unit 10 respectively.

Accordingly, a directional coupler 54 is provided which reminds of a Bruene bridge or rather a Bruene directional coupler as the currents and the voltages are taken of a live line such that the forward and rearward power can be determined. In contrast to a Bruene coupler, a measuring element containing ferrite, in particular a ferrite core encircling the line to be scanned, is not used as the current is directly measured without any ferrite containing element via the measuring coil 12 being arranged (directly) adjacent to the line 58.

The antenna can be adapted, in particular the impedances, by the directional coupler 54 or rather the scanning unit 10 because of the active impedance matching circuit 14 over a wide frequency range, in particular for frequencies between 1 MHz and 30 MHz.

The directional coupler 54 has a sharpness of directivity being larger than 25 dB for the whole frequency range between 1 MHz and 30 MHz. Thus, the directional coupler 54 is a broadband directional coupler. Particularly, a directivity of more than 30 dB is provided in the frequency range of 1 MHz to 6 MHz. The linearity of the directional coupler 54 is 1 dB over the whole frequency range. Further, the directional coupler 54 is configured to measure signals having a power between 5 mW and 2 kW, in particular between 10 mW and 1 kW.

Despite the fact that the directional coupler 54 is a broadband directional coupler, the dimensions of the directional coupler 54 are reduced.

Further, the measurement system 57 may comprise a vector network analyzer, an oscilloscope and/or a spectrum analyzer. For instance, the vector network analyzer is connected to the directional coupler 54 such that decoupled signals can be analyzed accordingly by the vector network analyzer for gathering further information.

In general, the measurement system 57 can be formed by a device comprising the scanning unit 10 and a vector network analyzer, an oscilloscope and/or a spectrum analyzer.

## Claims

1. Directional coupler (54) for high-frequency applications comprising a scanning unit (10), wherein the scanning unit (10) comprises a measuring coil (12) and a current-to-voltage converter (16) which is connected to the measuring coil (12) wherein the scanning unit (10) is configured such that a current is measured in an inductive manner by the measuring coil (12), **characterized in that** the directional coupler (54) is formed on a printed circuit board (56).

2. Directional coupler (54) according to claim 1, **characterized in that** the directional coupler (54) is a broadband directional coupler.

3. Directional coupler (54) according to claim 1 or 2, **characterized in that** the scanning unit (10) further comprises an active impedance matching circuit (14) having the current-to-voltage converter (16) and wherein a feedback network (22) is provided which has at least one resistance (28, 30).

4. Directional coupler (54) according to claim 3, **characterized in that** at least one capacitor (32, 34) is provided being connected parallel to the at least one resistance (28, 30) in order to provide an electrical bypass (36, 38) of the at least one resistance (28, 30).

5. Directional coupler (54) according to any of the preceding claims, **characterized in that** the current-to-voltage converter (16) comprises a transistor network.

6. Directional coupler (54) according to any of the preceding claims, **characterized in that** the current-to-voltage converter (16) comprises an operational amplifier (17).

7. Directional coupler (54) according to any of the preceding claims, **characterized in that** a bypass line connects the measuring coil (12) and an output of the scanning unit (10) directly wherein the bypass line is switchable.

8. Directional coupler (54) according to any of the preceding claims, **characterized in that** a capacitor (44, 46) is connected in series with the current-to-voltage converter (16) wherein the capacitor (44, 46) is provided on the outlet side of the current-to-voltage converter (16).

9. Directional coupler (54) according to any of the preceding claims, **characterized in that** a balun circuit (48) is provided on the outlet side of the current-to-voltage converter (16) wherein the balun circuit (48) has a symmetrical port (50).

10. Directional coupler (54) according to any of the preceding claims, **characterized in that** the scanning unit (10) comprises a bias tee (52) for applying an operating voltage.

11. Directional coupler (54) according to any of the preceding claims, **characterized in that** an adjustable filter is provided.

12. Directional coupler (54) according to any of the preceding claims, **characterized in that** the scanning unit (10) is ferrite-less.

13. Directional coupler (54) according to any of the preceding claims, **characterized in that** the directional coupler (54) comprises an adding unit (66) and/or a subtracting unit (68) for determining the forward and backward power.

14. Measuring system (57) comprising a directional coupler (54) according to any of the preceding claims.

15. Measuring system (57) according to claim 14, **characterized in that** the measuring system (57) further comprises a vector network analyzer, an oscilloscope and/or a spectrum analyzer.

## Patentansprüche

1. Richtkoppler (54) für Hochfrequenzanwendungen mit einer Abtasteinheit (10), wobei die Abtasteinheit (10) eine Messspule (12) und einen mit der Messspule (12) verbundenen Strom-Spannungs-Wandler (16) umfasst, wobei die Abtasteinheit (10) derart konfiguriert ist, dass ein Strom induktiv von der Messspule (12) gemessen wird, **dadurch gekennzeichnet, dass** der Richtkoppler (54) auf einer Leiterplatte (56) ausgebildet ist.

2. Richtkoppler (54) nach Anspruch 1, **dadurch gekennzeichnet, dass** der Richtkoppler (54) ein Breitband-Richtkoppler ist.

3. Richtkoppler (54) nach Anspruch 1 oder 2, **dadurch gekennzeichnet, dass** die Abtasteinheit (10) ferner eine aktive Impedanzanpassungsschaltung (14) umfasst, die den Strom-Spannungs-Wandler (16) aufweist, und wobei ein Rückkopplungsnetzwerk (22) vorgesehen ist, das mindestens einen Widerstand (28, 30) aufweist.

4. Richtkoppler (54) nach Anspruch 3, **dadurch gekennzeichnet, dass** mindestens ein Kondensator (32, 34) vorgesehen ist, der parallel zu dem mindestens einen Widerstand (28, 30) geschaltet ist, um eine elektrische Überbrückung (36, 38) des mindestens einen Widerstands (28, 30) bereitzustellen.

5. Richtkoppler (54) nach einem der vorstehenden Ansprüche, **dadurch gekennzeichnet, dass** der Strom-Spannungs-Wandler (16) ein Transistornetzwerk umfasst.

6. Richtkoppler (54) nach einem der vorstehenden Ansprüche, **dadurch gekennzeichnet, dass** der Strom-Spannungs-Wandler (16) einen Operationsverstärker (17) umfasst.

7. Richtkoppler (54) nach einem der vorstehenden Ansprüche, **dadurch gekennzeichnet, dass** eine Überbrückungsleitung die Messspule (12) und einen Ausgang der Abtasteinheit (10) direkt verbindet, wobei die Überbrückungsleitung umschaltbar ist.

8. Richtkoppler (54) nach einem der vorstehenden Ansprüche, **dadurch gekennzeichnet, dass** ein Kondensator (44, 46) in Reihe mit dem Strom-Spannungs-Wandler (16) geschaltet ist, wobei der Kondensator (44, 46) auf der Ausgangsseite des Strom-Spannungs-Wandlers (16) vorgesehen ist.

9. Richtkoppler (54) nach einem der vorstehenden Ansprüche, **dadurch gekennzeichnet, dass** eine Balun-Schaltung (48) auf der Ausgangsseite des Strom-Spannungs-Wandlers (16) vorgesehen ist, wobei die Balun-Schaltung (48) einen symmetrischen Anschluss (50) aufweist.

10. Richtkoppler (54) nach einem der vorstehenden Ansprüche, **dadurch gekennzeichnet, dass** die Abtasteinheit (10) eine T-förmige Trennschaltung (52) zum Anlegen einer Betriebsspannung umfasst.

11. Richtkoppler (54) nach einem der vorstehenden Ansprüche, **dadurch gekennzeichnet, dass** ein einstellbares Filter vorgesehen ist.

12. Richtkoppler (54) nach einem der vorstehenden Ansprüche, **dadurch gekennzeichnet, dass** die Abtasteinheit (10) ferritfrei ist.

13. Richtkoppler (54) nach einem der vorstehenden Ansprüche, **dadurch gekennzeichnet, dass** der Richtkoppler (54) einen Addierer (66) und/oder einen Subtrahierer (68) zur Bestimmung der Vorwärts- und Rückwärtsleistung umfasst.

14. Messsystem (57) mit einem Richtkoppler (54) nach einem der vorstehenden Ansprüche.

15. Messsystem (57) nach Anspruch 14, **dadurch gekennzeichnet, dass** das Messsystem (57) ferner einen Vektornetzwerk-Analysator, ein Oszilloskop und/oder einen Spektrumanalysator umfasst.

## Revendications

1. Coupleur directionnel (54) pour applications à haute fréquence, comprenant une unité de balayage (10), dans lequel l'unité de balayage (10) comprend une bobine de mesure (12) et un convertisseur courant-tension (16) qui est connecté à la bobine de mesure (12), dans lequel l'unité de balayage (10) est configurée de manière qu'un courant soit mesuré de façon inductive par la bobine de mesure (12), **caractérisé en ce que** le coupleur directionnel (54) est formé sur une carte de circuit imprimé (56).

2. Coupleur directionnel (54) selon la revendication 1, **caractérisé en ce que** le coupleur directionnel (54) est un coupleur directionnel à large bande.

3. Coupleur directionnel (54) selon la revendication 1 ou 2, **caractérisé en ce que** l'unité de balayage (10) comprend en outre un circuit actif d'adaptation d'impédance (14) comportant le convertisseur courant-tension (16) et dans lequel est placé un réseau de rétroaction (22) qui comporte au moins une résistance (28, 30).

4. Coupleur directionnel (54) selon la revendication 3, **caractérisé en ce qu'**est mis en place au moins un condensateur (32, 34) connecté en parallèle à l'au moins une résistance (28, 30) afin de procurer une dérivation électrique (36, 38) de l'au moins une résistance (28, 30).

5. Coupleur directionnel (54) selon l'une quelconque des revendications précédentes, **caractérisé en ce que** le convertisseur courant-tension (16) comprend un réseau de transistors.

6. Coupleur directionnel (54) selon l'une quelconque des revendications précédentes, **caractérisé en ce que** le convertisseur courant-tension (16) comprend un amplificateur opérationnel (17).

7. Coupleur directionnel (54) selon l'une quelconque des revendications précédentes, **caractérisé en ce qu'**une ligne de dérivation connecte directement la bobine de mesure (12) et une sortie de l'unité de balayage (10), dans lequel la ligne de dérivation est commutable.

8. Coupleur directionnel (54) selon l'une quelconque des revendications précédentes, **caractérisé en ce qu'**un condensateur (44, 46) est connecté en série avec le convertisseur courant-tension (16), dans lequel le condensateur (44, 46) est placé du côté sortie du convertisseur courant-tension (16).

9. Coupleur directionnel (54) selon l'une quelconque des revendications précédentes, **caractérisé en ce qu'**un circuit symétriseur (48) est placé du côté sortie du convertisseur courant-tension (16), dans lequel le circuit symétriseur (48) a un accès symétrique (50).

10. Coupleur directionnel (54) selon l'une quelconque des revendications précédentes, **caractérisé en ce que** l'unité de balayage (10) comprend un té de polarisation (52) destiné à appliquer une tension de fonctionnement.

11. Coupleur directionnel (54) selon l'une quelconque des revendications précédentes, **caractérisé en ce qu'**un filtre réglable est mis en place.

12. Coupleur directionnel (54) selon l'une quelconque des revendications précédentes, **caractérisé en ce que** l'unité de balayage (10) est sans ferrite.

13. Coupleur directionnel (54) selon l'une quelconque des revendications précédentes, **caractérisé en ce que** le coupleur directionnel (54) comprend une unité d'addition (66) et/ou une unité de soustraction (68) permettant de déterminer la puissance directe et réfléchie.

14. Système de mesure (57) comprenant un coupleur directionnel (54) selon l'une quelconque des revendications précédentes.

15. Système de mesure (57) selon la revendication 14, **caractérisé en ce que** le système de mesure (57) comprend en outre un analyseur de réseau vectoriel, un oscilloscope et/ou un analyseur de spectre.
